# EUROPÄISCHE PATENTSCHRIFT

(11) **EP 2 137 914 B1**
(45) Veröffentlichungstag und Bekanntmachung des Hinweises auf die Patenterteilung: **26.12.2012**
(21) Anmeldenummer: 08749061.1
(22) Anmeldetag: 23.04.2008
(51) Int. Cl.: H04L 25/02, H03K 19/00

(54) **LIN-RECEIVER**
LIN RECEIVER
RÉCEPTEUR LIN

(30) Priorität: 23.04.2007 DE 102007019356
(43) Veröffentlichungstag der Anmeldung: 30.12.2009
(73) Patentinhaber: Micronas GmbH, 79108 Freiburg (DE)
(72) Erfinder: HORN, Wolfgang, A-9020 Klagenfurt (AT)
(74) Vertreter: Koch Müller Patentanwaltsgesellschaft mbH
(86) Internationale Anmeldenummer: PCT/EP2008/003259
(87) Internationale Veröffentlichungsnummer: WO 2008/128763

(56) Entgegenhaltungen:
- EP-A- 1 404 078
- US-A- 4 103 190

## Beschreibung

Die Erfindung bezieht sich auf einen LIN-Receiver mit Sleep/Wake-up-Funktionalität gemäß den oberbegrifflichen Merkmalen gemäß Patentanspruch 1.

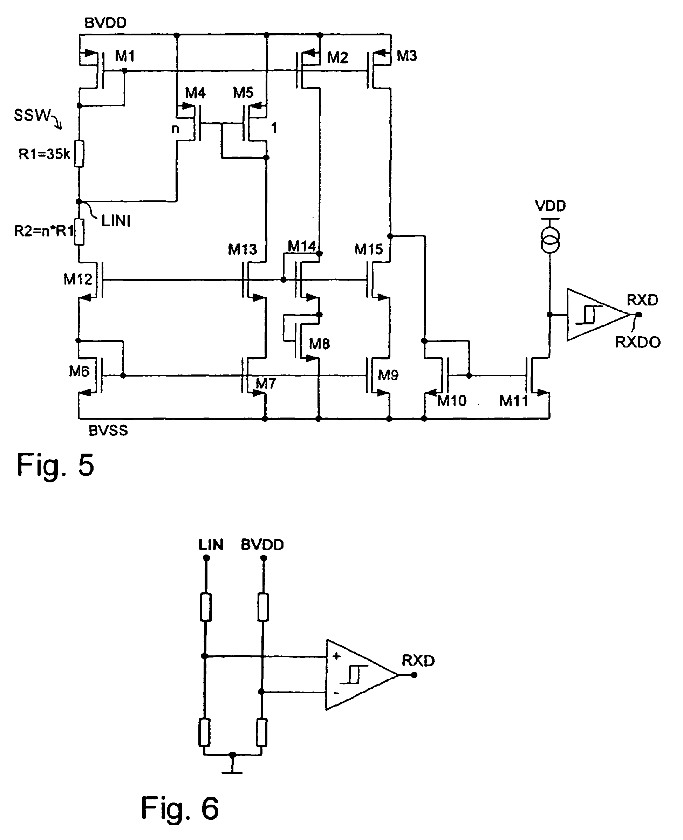

LIN-Receiver (LIN: Local Interconnect Network/lokales Verbindungsnetz) sind ausgelegt, einen Pegel an einem LIN-Bus zu erkennen. Gemäß der LIN-Spezifikation 2.1, Seite 115, werden Spannungsteiler mit unterschiedlichen Teilungsverhältnissen am LIN-Bus und an der Versorgung, insbesondere einer Batterie, verwendet, um einen LIN-Pegel am Bus auszuwerten. Fig. 6 zeigt eine beispielhafte Anordnung gemäß dem derzeitigen Stand der Technik. Zwischen einer Grundspannung GND und einem Anschluss bzw. Eingang LINI zum LIN-Bus ist eine Spannungsteilerkette aus zwei Widerständen geschaltet. Eine weitere Spannungsteilerkette aus ebenfalls zwei Widerständen ist zwischen Masse GND und eine positive Versorgungsspannung des Busses BVDD geschaltet. Der Anschluss für die Masse GND kann auch als negative Versorgungsspannung des Busses geschaltet sein. Kontaktpunkte zwischen den beiden jeweiligen Widerständen der beiden Spannungsteilerketten führen zu einem positiven bzw. einem negativen Eingang eines Operationsverstärkers mit einem Ausgang RXDO[A1], an welchem Daten, insbesondere Empfangsdaten RXD in für sich bekannter Art und Weise angelegt werden.

Nachteilig bei einer solchen Lösung ist der permanente Stromverbrauch der Teilerketten sowie die erforderliche Chipfläche für die Implementierung hoch-ohmiger Widerstände. Dies macht eine Abwägung zwischen Stromverbrauch und Chipfläche erforderlich. Um eine Sleep-Funktion (Schlaffunktion) zu realisieren, können die Teilerketten abgeschaltet werden. Dies hat jedoch zur Folge, dass der Pegel am LIN-Bus nicht mehr korrekt ausgewertet werden kann und eine Wake-Funktion (Aufwachfunktion) über den LIN-Bus nicht mehr möglich ist. Dementsprechend weisen derzeit verfügbare LIN-Receiver und LIN-Transceiver mit integrierter Receiver-Funktion einen relativ hohen Stromverbrauch im Sleep-Modus auf.

Aus der EP 1 404 078 A1 ist ein LIN Receiver mit wake - up Funktionalität bekannt. Hierbei wird bei anliegendem rezessiven Pegel der Pull - Up Zweig stromlos geschaltet. Des Weiteren ist aus der US 4 193 190 eine Stromsparschaltung mit Inverterketten bekannt.

Die Aufgabe der Erfindung besteht darin, eine Schaltungsanordnung bzw. einen LIN-Receiver mit einer entsprechenden Schaltungsanordnung vorzuschlagen, welche eine Reduzierung des Stromverbrauchs im Sleep-Modus ermöglichen.

Diese Aufgabe wird gelost durch einen LIN-Receiver mit Sleep / Wake-up-Funktionalität mit den Merkmalen gemäβ Patentanspruch 1. Vorteilhafte Ausgestaltungen sind Gegenstand abhängiger Ansprüche.

Bevorzugt wird demgemäß insbesondere ein LIN-Receiver mit Sleep / Wake-up- Funktionalität, der einen Eingang zu einem LIN-Bus, einen Ausgang und Anschüsse für zumindest eine Versorgungsspannung aufweist, wobei der LIN-Receiver zusätzlich Transistoren aufweist, welche geschaltet sind zum Aktivieren des Receivers bei rezessivem Zustand des LIN-Busses durch einen Zustandswechsel am LIN-Bus in einen aktiven Zustand des Receivers.
Dabei muss ein LIN-Receiver nicht zwingend als eine eigenständige Komponente verstanden werden. Auch entsprechende Schaltungsanordnungen, insbesondere Schaltungsanordnungen in übergeordneten Vorrichtungen mit einer solchen LIN-Receiver Funktionalität fallen darunter. Dies gilt insbesondere für LIN-Transceiver, welche neben einer Receiver- Funktionalität zusätzlich auch eine Sende- Funktionalität aufweisen.

Insbesondere zeichnet sich ein derart bevorzugter LIN-Receiver durch eine sehr geringe Stromaufnahme im rezessiven Zustand des LIN-Busses, das heißt in der Sleep-Funktion, aus. Trotzdem kann der Receiver automatisch aktiviert werden durch einen Zustandswechsel am LIN-Bus in den aktiven bzw. dominanten Zustand, womit eine Wake-up-Funktionalität gegeben ist. Während des Aufwachens bzw. Aktivierens oder danach kann der LIN-Receiver dann ein Signal erzeugen, mit welchem z. B. über einen Interrupt ein Prozessor aktiviert werden kann.

Es ergibt sich somit eine Vielzahl von Vorteilen. Ausgenommen von Leckströmen entfällt eine Stromaufnahme im Sleep-Betrieb. Je nach Ausführungsform sind keine hoch-ohmigen Spannungsteiler erforderlich. Auch im aktiven Betrieb ist nur eine geringe Stromaufnahme erforderlich. Ermöglicht wird insbesondere auch ein automatisches Aktivieren der Schaltung bei Aktivität am LIN-Bus, so dass ein gesondertes Wake-up-Signal nicht erforderlich ist. Die Hysterese ist vorteilhafterweise proportional zur Versorgungsspannung.

Erfindungsgemäβ ist bei einem solcher LIN-Receiver vorgesehen, dass der Eingang zwischen Komponenten eines Spannungs-zu-Strom-Wandlers geschaltet ist, insbesondere zwischen einen ersten und einen zweiten Widerstand geschaltet ist.

Dabei ist ein erster Widerstand des Spannungs-zu-Strom-Wandlers derart als Pull-up-Widerstand geschaltet und dimensioniert, dass bei dominantem Pegel am Eingang Strom über den ersten Widerstand fließt. Zumindest ein erster, zweiter und dritter der Transistoren sind bevorzugt geschaltet, den Stromfluss über den ersten Widerstand zu spiegeln, und zumindest ein achter und ein vierzehnter Transistor und als Kaskode-Transistoren geschaltete weitere zwölfte, dreizehnte und fünfzehnte Transistoren sind bevorzugt geschaltet zum Aktivschalten des LIN-Receivers und/oder des Ausgangs[A2].

Bei dem LIN-Receiver ist vorteilhaft ein zweiter Widerstand des Spannungs-zu-Strom-Wandlers mittels Transistoren auf eine negative Versorgungsspannung oder Masse schaltbar geschaltet.

Zumindest ein dritter und ein fünfzehnter Transistor können zwischen eine positive Versorgungsspannung und die negative Versorgungsspannung oder Masse geschaltet sein zum Vergleichen eines Stromflussanteils durch den ersten Widerstand und eines Stromflussanteils durch den zweiten Widerstand.

Ein zehnter und ein elfter Transistor können ausgangsseitig mit dem dritten und dem fünfzehnten Transistor geschaltet sein, den Ausgang nach Masse oder der negativen Versorgungsspannung des Busses zu ziehen.

Insbesondere können zumindest ein vierter, ein fünfter und ein siebter Transistor derart zwischen die positive Versorgungsspannung und die negative Versorgungsspannung oder Masse geschaltet sein, dass ein Stromflussanteil durch den zweiten Widerstand des Spannungs-zu-Strom-Wandlers den Gateanschluss des siebten Transistors und darüber über den vierten und den fünften Transistor ansteuert, den Stromanteil durch den zweiten Widerstand zu kompensieren. Durch den vierten und fünften der Transistoren wird dabei der Strom auf den Eingang gespiegelt. Vom LIN-Bus aus betrachtet, wird der zweite Widerstand somit unsichtbar.

Außerdem können zumindest ein achter und ein vierzehnter Transistor derart zwischen die positive Versorgungsspannung und die negative Versorgungsspannung oder Masse geschaltet sein, dass sie einen Stromfluss durch den zweiten Widerstand bei rezessivem Pegel am Eingang mittels eines Schalters ausschalten. Das Ausschalten kann durch z.B. einen mit diesen Transistoren angesteuerten zwölften Transistor erfolgen, welcher zwischen den zweiten Widerstand und die negative Versorgungsspannung bzw. Masse geschaltet ist. Letztendlich wird dadurch die gesamte Schaltung stromlos. Dadurch ergibt sich eine allenfalls geringe Stromaufnahme, welche sich im rezessiven Zustand sowohl am LIN-Bus als auch am Versorgungsanschluss auf Leckströme beschränkt.

Ein Schalter und zum Erzeugen einer Hysterese ein siebzehnter Transistor können als zusätzliche Komponenten in Reihe zwischen den zweiten Widerstand und die negative Versorgungsspannung oder Masse geschaltet sein, wobei der Schalter dann geschaltet ist, abhängig von einem Schaltungszustand am Ausgang einen Stromfluss durch den siebzehnten Transistor ein- oder auszuschalten. Durch eine solche Schaltungsanordnung ergibt sich eine Hysterese, deren Wert nicht konstant, sondern proportional zur Versorgungsspannung ist. Dieses Verhalten ist vorteilhaft, da sich die Definition der Hysterese in der LIN-Spezifikation auf die Versorgungsspannung bezieht.

Die Transistoren können allgemein mittels Skalierungsfaktoren derart dimensioniert sein, alle Ströme außer jenem durch einen auf die positive Versorgungsspannung schaltbaren ersten Widerstand des Spannungs-zu-Strom-Wandlers entsprechend zu reduzieren. Dabei sind auch hohe Skalierungsfaktoren möglich, weil die Geschwindigkeitsanforderungen bei derartigen LIN-Receivern gering sind, wenn die maximale Frequenz des LIN-Busses bei insbesondere fmax(LIN) = 20kHz liegt.

Ein sechzehnter Transistor kann als eine integrierte Verpolschutz-Diode zwischen eine positive Versorgungsspannung und die weiteren Transistoren geschaltet sein. Durch eine entsprechende Verschaltung des Gates des sechzehnten Transistors befindet sich dieser bei normal gepolter Versorgungsspannung des Busses im Rdson-Betrieb, wodurch ein entstehender Spannungsabfall bei entsprechender Dimensionierung vernachlässigt werden kann.

Soweit die genannten Transistoren nummeriert bezeichnet sind, handelt es sich lediglich um ein diese bezeichnendes Merkmal zur Unterscheidung der einzelnen der Transistoren und nicht um eine Nummerierung im Sinne einer zahlenmäßigen Auflistung.

Gemäß besonders hervorzuhebender Aspekte werden somit Nachteile je nach Ausgestaltung der Ausführungsformen beseitigt durch die Eliminierung der Teilerkette an der Versorgung bzw. Versorgungsspannung durch Verwendung des gemäß LIN-Spezifikation vorgeschriebenen Pull-up-Widerstandes zur Signalauswertung. Außerdem kann eine Deaktivierung der gesamten Schaltung bei rezessivem Zustand am LIN-Bus erfolgen. Bei nicht-rezessivem Zustand am LIN-Bus kann eine automatische Aktivierung erfolgen.

Ein Ausführungsbeispiel wird nachfolgend anhand verschiedener Ausführungsformen beschrieben. Gleiche Bezugszeichen in den verschiedenen Figuren verweisen dabei auf gleiche oder gleich wirkende Komponenten und Funktionen, so dass insbesondere bei den erweiterten Ausführungsformen bezüglich solcher gleicher Bezugszeichen auch auf die Ausführungen der übrigen und insbesondere jeweils vorstehenden Figuren verwiesen wird. Allgemein gilt dabei, dass Komponenten der weiteren Ausführungsformen natürlich auch ohne zwischengeschaltet beschriebene Ausführungsformen direkt mit der ersten Ausführungsform kombinierbar sind. Es zeigen:
- Fig. 1: eine Schaltungsanordnung eines ersten bevorzugten LIN-Receivers,
- Fig. 2: eine zweite Schaltungsanordnung eines demgegenüber modifizierten LIN-Receivers,
- Fig. 3: eine gegenüber Fig. 2 weiter modifizierte Ausführungsform eines LIN-Receivers,
- Fig. 4: eine noch weiter modifizierte Ausführungsform eines derartigen LIN-Receivers,
- Fig. 5: eine weitere gegenüber Fig. 1 modifizierte Ausführungsform eines derartigen LIN-Receivers, und
- Fig. 6: eine beispielhafte Anordnung gemäß dem Stand der Technik.

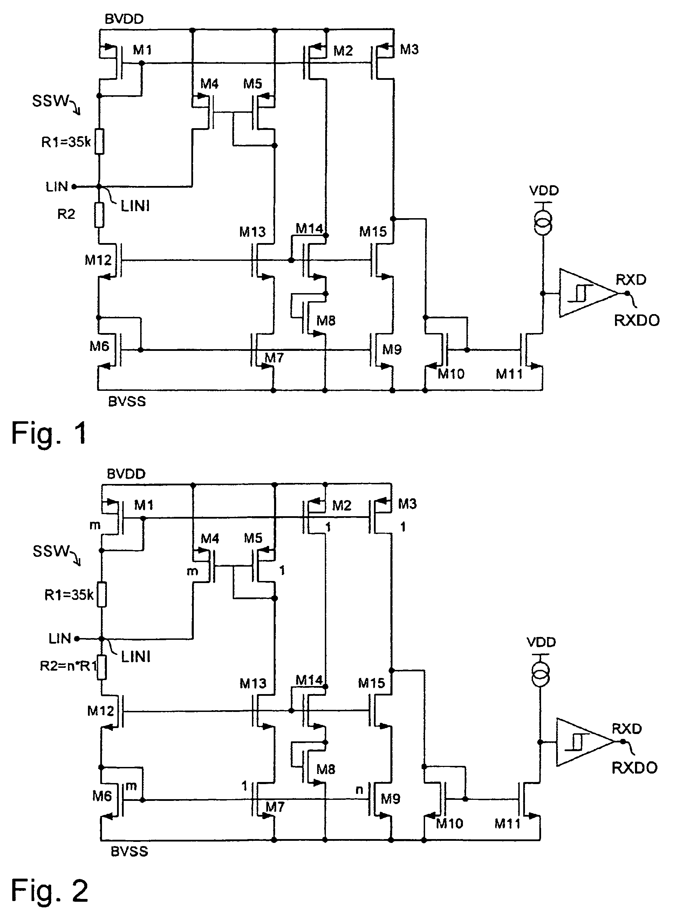

Fig. 1 zeigt eine beispielhafte Schaltungsanordnung mit einem Eingang LINI als Anschlusspunkt für einen LIN-Bus LIN, einem Ausgang RXDO, an welchem Empfangsdaten RXD abgreifbar sind, eine positive Versorgungsspannung des Busses BVDD sowie eine negative Versorgungsspannung des Busses BVSS. In für sich bekannter Art und Weise ist bezüglich der negativen und der positiven Versorgungsspannung des Busses BVSS, BVDD deren Relativ-Verhältnis relevant. Insbesondere die negative Versorgungsspannung kann optional auch Masse bzw. dem Erdanschluss entsprechen. Außerdem ist eine Versorgungsspannung VDD an der Schaltungsanordnung angelegt.

Der Eingang LINI ist zwischen einen ersten und einen zweiten Ohm'schen Widerstand R1, R2 geschaltet. Beispielhaft kann der erste Widerstand R1 einen Widerstandswert von 35k aufweisen. Der erste und der zweite Widerstand R1, R2 bilden somit einen Spannungs-zu-Strom-Wandler SSW aus.

Der dem Eingang LINI abgewandte Anschluss des ersten Widerstands R1 ist an einen ersten Transistor M1 geschaltet, und zwar an Drain und Gate. Der erste Transistor M1 ist außerdem mit Source und Bulk an die positive Versorgungsspannung des Busses BVDD geschaltet. Außerdem ist der dem Eingang LINI abgewandte zweite Anschluss des ersten Widerstandes R1 an einen zweiten Transistor M2 und an einen dritten Transistor M3 geschaltet, und zwar jeweils an deren Gate. Der zweite und der dritte Transistor M2, M3 sind jeweils mit ihren Anschlüssen Source und Bulk an die positive Versorgungsspannung des Busses BVDD geschaltet.

Außerdem liegt die positive Versorgungsspannung des Busses BVDD an einem vierten und an einem fünften Transistor M4, M5 an, und zwar jeweils an deren Source- und Bulk-Anschlüssen. An Drain des vierten Transistors M4 liegt außerdem der Eingang LINI an. Die Gate-Anschlüsse des vierten und des fünften Transistors M4, M5 sind an Drain des fünften Transistors M5 geschaltet.

Der dem Eingang LINI abgewandte zweite Anschluss des zweiten Widerstandes R2 ist über einen zwölften und einen sechsten Transistor M12, M6 an die negative Versorgungsspannung des Busses BVSS anlegbar. Dabei ist der zweite Widerstand R2 an Source des zwölften Transistors M12 geschaltet, Drain des zwölften Transistors M12 an Source und Gate des sechsten Transistors M6 geschaltet und Drain des sechsten Transistors M6 an die negative Versorgungsspannung des Busses BVSS geschaltet.

Der zwölfte Transistors M12 liegt mit seinem Gate-Anschluss an einem gemeinsamen Knoten mit Gate-Anschlüssen eines dreizehnten Transistors M13, eines vierzehnten Transistors M14 und eines fünfzehnten Transistors M15 an. Außerdem liegt dieser Knoten an Source des vierzehnten Transistors M14 und an Drain des zweiten Transistors M2 an. Source des dreizehnten Transistors M13 liegt außerdem am Gate-Anschluss des vierten und des fünften Transistors M5 an. Außerdem liegt Source des fünfzehnten Transistors M15 an Drain des dritten Transistors M3 an.

Der Gate-Anschluss des sechsten Transistors M6 ist gemeinsam geschaltet mit Gate-Anschlüssen eines siebten Transistors M7 und eines neunten Transistors M9. Drain des dreizehnten Transistors M13 liegt an Source des siebten Transistors M7 an und Drain des siebten Transistors M7 liegt an der negativen Versorgungsspannung des Busses BVSS an. Drain des vierzehnten Transistors M14 liegt an Source und Gate eines achten Transistors M8 an. Drain des achten Transistors M8 liegt an der negativen Versorgungsspannung des Busses BVSS an. Der neunte Transistor M9 ist mit Source an Drain des fünfzehnten Transistors M15 und mit Drain an die negative Versorgungsspannung des Busses BVSS geschaltet.

Ein zehnter und ein elfter Transistor M10, M11 sind mit ihren Gate-Anschlüssen sowohl an Source des zehnten Transistors M10 als auch an Drain des dritten Transistors M3 geschaltet. Mit ihren Drain-Anschlüssen sind der zehnte und der elfte Transistor M10, M11 jeweils auf die negative Versorgungsspannung des Busses BVSS geschaltet. Drain des elften Transistors M11 ist sowohl an eine Stromquelle geschaltet, deren weiterer Eingang der Versorgungsspannung VDD entspricht, als auch an einen Schmitt-Trigger geschaltet, dessen Ausgangsanschluss dem Ausgang RXDO entspricht.

Vorzugsweise sind die ersten fünf der Transistoren M1 - M5 als MOSFETs ausgestaltet. Prinzipiell ist aber generell auch der Einsatz von Bipolar-Transistoren statt MOSFETs möglich.

Hinsichtlich der Funktionalität entspricht der erste Widerstand R1 dem gemäß der LIN-Spezifikation vorgeschriebenen Pull-up-Widerstand. Bei dominantem Pegel (low) am LIN-Bus bzw. am Eingang LINI fließt Strom über den ersten Widerstand R1. Dieser Stromfluss wird über die Anordnung aus den ersten, zweiten und dritten Transistoren M1 - M3 gespiegelt und aktiviert über den achten und den vierzehnten Transistor M8, M14 und die als Kaskode-Transistoren geschalteten zwölften, dreizehnten und fünfzehnten Transistoren M12, M13, M15. Somit fließt auch über den zweiten Widerstand R2 ein Strom, welcher durch den sechsten, siebten und neunten Transistor M6, M7, M9 gespiegelt wird.

An der Verbindung des dritten und des fünfzehnten Transistors M3, M15 werden die beiden Stromanteile durch die beiden Widerstände R1, R2 verglichen. Überwiegt der Anteil durch den ersten Widerstand R1, kommt es zu einem Stromfluss in dem zehnten Transistor M10, welcher über den elften Transistor M11 gespiegelt wird und dadurch den Ausgang RXDO nach Masse bzw. der negativen Versorgungsspannung des Busses BVSS zieht.

Der Stromanteil durch den zweiten Widerstand R2 ist dabei prinzipiell unerwünscht, zumal er in der LIN-Spezifikation nicht vorgesehen ist. Daher wird der Stromanteil durch den zweiten Widerstand R2 vorzugsweise kompensiert. Zu diesem Zweck wird der Strom von dem siebten Transistor M7 über den fünften und den vierten Transistor M5, M4 auf den Eingang LINI gespiegelt. Vom LIN-Bus LIN aus betrachtet, wird der zweite Widerstand R2 somit unsichtbar.

Bei rezessivem Pegel am LIN-Bus (high) gibt es keinen Stromfluss im ersten Widerstand R1, wodurch der achte und der vierzehnte Transistor M8, M14, welche als MOS-Dioden geschaltet sind, ausgeschaltet werden. Durch den zwölften Transistor M12 wird dadurch der Stromfluss im zweiten Widerstand R2 unterbunden und die gesamte Schaltung wird stromlos. Dadurch ergibt sich keine hohe Stromaufnahme, welche sich sowohl am LIN-Bus LIN als auch am Versorgungsanschluss auf Leckströme beschränkt.

Fig. 2 zeigt eine modifizierte Ausführungsform, welche dazu dient, den Stromverbrauch im aktiven Betrieb zu reduzieren. Dazu können Skalierungsfaktoren n und/oder m eingeführt werden. Beispielhaft ist ein zweiter Skalierungsfaktor m am ersten, vierten und sechsten Transistor M1, M4, M6 vorgesehen, ein Faktor 1 am zweiten, dritten, fünften und siebten Transistor M2, M3, M5, M7 und ein erster Skalierungsfaktor n am neunten Transistor M9 vorgesehen. Der zweite Widerstand R2 ist dimensioniert gemäß dem Produkt aus dem ersten Skalierungswert n und dem Widerstandswert, z. B. 35k, des ersten Widerstands R1. Dadurch reduzieren sich alle Ströme außer jener durch den ersten Widerstand R1 entsprechend. Da die Geschwindigkeitsanforderungen bei derartigen LIN-Receivern gering sind, da die maximale Frequenz des LIN-Busses bei fmax(LIN) = 20kHz liegt, können entsprechend hohe Skalierungsfaktoren gewählt werden.

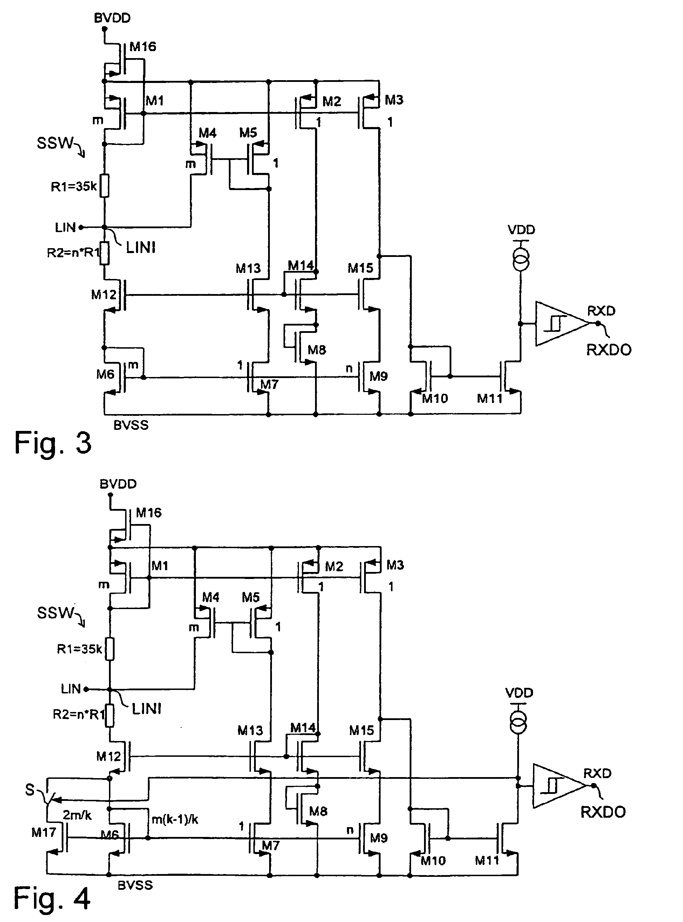

Fig. 3 zeigt eine Ausführungsform, welche gegenüber der Ausführungsform gemäß Fig. 2 um einen sechzehnten Transistor M16 erweitert ist, welcher vorzugsweise wieder ein MOSFET ist. Wie dies auch für die übrigen Transistoren gilt, können jedoch auch entsprechende Schaltungen mit bipolaren Transistoren anstelle von Feldeffekttransistoren aufgebaut werden. Der sechzehnte Transistor M16 dient als eine integrierte Verpolschutz-Diode, wobei der sechzehnte Transistors M16 mit seinem Gate dem Gate des ersten Transistors M1 verschaltet ist. Drain und Source sind zwischen die positive Versorgungsspannung des Busses BVDD und die Source-Anschlüsse des ersten bis fünften Transistors M1 - M5 geschaltet. Somit liegt die positive Versorgungsspannung des Busses BVDD nicht mehr direkt an letztgenannten an. Durch die Verschaltung des Gates des sechzehnten Transistors M16 befindet sich dieser bei normal gepolter Versorgungsspannung des Busses BVDD im Rdson-Betrieb (Rdson: Einschaltwiderstand bzw. Drain-Source-Widerstand), wodurch der entstehende Spannungsabfall bei entsprechender Dimensionierung vernachlässigt werden kann.

Fig. 4 zeigt eine noch weiter modifizierte Ausführungsform, welche zusätzliche Komponenten gegenüber der in Fig. 3 dargestellten Ausführungsform aufweist.

Die Schaltungsanordnung gemäß Fig. 4 implementiert zusätzlich eine Hysterese durch Einsatz eines siebzehnten Transistors M17, welcher beispielsweise als bipolarer Transistor ausgestaltet ist. Außerdem weist die Anordnung einen Schalter S auf, welcher z. B. als NMOS-Transistor ausgeführt sein kann. Im einzelnen ist der siebzehnte Transistors M17 mit seinem Gate mit unter anderem dem Gate des sechsten Transistors M6 verbunden und wird entsprechend dem sechsten Transistor M6 angesteuert. Source des siebzehnten Transistors M17 ist auf die negative Versorgungsspannung des Busses BVSS geschaltet. Drain des siebzehnten Transistors M17 ist an einen der Anschlüsse des Schalters S geschaltet. Der andere Anschluss des Schalters S ist mit dem Source-Anschluss des zwölften Transistors M12 verbunden. Geschaltet wird der Schalter S durch eine Verbindung zu einem Knoten, welcher den Drain-Anschluss des elften Transistors M11 mit dem Schmitt-Trigger und der Spannungsquelle verbindet. Durch eine solche Schaltungsanordnung ergibt sich eine Hysterese, deren Wert nicht konstant sondern proportional zur Versorgungsspannung BVDD ist. Dieses Verhalten ist vorteilhaft, da sich die Definition der Hysterese in der LIN-Spezifikation auf die Versorgungsspannung BVDD bezieht.

Neben den verschiedenen dargestellten Ausführungsformen ergibt sich eine Vielzahl weiterer Realisierungsmöglichkeiten zur Erzielung eines reduzierten oder gar gänzlich entfallenden Stromverbrauchs. Beispielsweise können Bipolar-Transistoren anstelle von MOSFETs verwendet werden.

Außerdem können zusätzliche Kaskoden, insbesondere NMOS und/oder PMOS, zur Erhöhung der Genauigkeit und/oder Spannungsfestigkeit in einer entsprechenden Schaltungsanordnung verwendet werden. Möglich ist auch die Verwendung zusätzlicher, die prinzipielle Funktionsweise nicht beeinflussender Schutzelemente, insbesondere Widerstände und/oder Zener-Dioden zur Erhöhung der Robustheit einer solchen Schaltungsanordnung.

Insbesondere ist auch die Auskopplung eines Stromsignals statt eines Spannungssignals durch entsprechende Umgestaltung der Schaltungsanordnungen möglich.

Vorteilhaft ist auch eine zusätzliche Umschaltung des siebten Transistors M7, um den Kompensationsstrom an die Hysterese-Umschaltung anzupassen, da bei den dargestellten Schaltungsanordnungen die Kompensation durch den Einfluss des Hysterese-Transistors noch nicht ganz ideal ist.

## Patentansprüche

1. LIN-Receiver mit Sleep / Wake-up- Funktionalität, aufweisend eine Schaltung mit,
- einem Eingang (LINI) als Anschlusspunkt zu einem LIN-Bus (LIN), mit einem rezessiven Zustand und einem dominanten Zustand, und
- einem Ausgang (RXDO), und Anschlüssen für zumindest eine positive Versorgungsspannung (BVDD),
- mit mehreren Transistoren, und
einem ersten Widerstand (R1) und einem zweiten Widerstand (R2) wobei der zweite Widerstand mit einer negativen Versorgungsspannung (BVSS) verschaltet ist,
**dadurch gekennzeichnet** durch, dass
der Eingang (LINI) zwischen dem ersten als pull- up ausgebildeten Widerstand (R1) und dem zweiten Widerstand (R2) geschaltet ist und in dem dominanten Zustand über den ersten Widerstand (R1), der als Komponente eines Strom-Spannungswandler (SSW) ausgeführt ist, ein Strom fließt und die Schaltung aktiviert ist, wobei durch den zweiten Widerstand ein Stromflussanteil fließt und der Stromflussanteil durch den zweiten Widerstand kompensiert ist, indem der Stromflussanteil auf den Eingang (LINI) gespiegelt ist, und die gesamte Schaltung bei dem rezessiven Pegel bis auf Leckströme stromlos ist.

2. LIN-Receiver nach Anspruch 1, mit
- zumindest ersten, zweiten und dritten Transistoren (M1 -M3), welche geschaltet sind den Stromfluss über den ersten Widerstand (R1) zu spiegeln, und
- zumindest einem achten und einem vierzehnten Transistor (M8, M14) und als Kaskade-Transistoren geschalteten weiteren zwölften, dreizehnten und fünfzehnten Transistoren (M12, M13, M15), welche geschaltet sind zum Aktivschalten des LIN-Receivers und/oder des Ausgangs (RXDO).

3. LIN-Receiver nach Anspruch 1 oder Anspruch 2, bei dem
- der zweite Widerstand (R2) ein Teil des Spannungs-zu-Strom-Wandlers (SSW) ist und mittels Transistoren (M12, M6) auf die negative Versorgungsspannung (BVSS) oder Masse schaltbar geschaltet ist.

4. LIN-Receiver nach Anspruch 3, bei dem zumindest ein dritter und ein fünfzehnter Transistor (M3, M15) zwischen die positive Versorgungsspannung (BVDD) und die negative Versorgungsspannung (BVSS) oder Masse geschaltet sind zum Vergleichen eines Stromflussanteils durch den ersten Widerstand (RI) und eines Stromflussanteils durch den zweiten Widerstand (R2).

5. LIN-Receiver nach Anspruch 4, bei dem ein zehnter und ein elfter Transistor (M10, M11) ausgangsseitig mit dem dritten und dem fünfzehnten Transistor (M3, M15) geschaltet sind, den Ausgang (RXDO) nach Masse oder der negativen Versorgungsspannung des Busses (BVSS) zu ziehen.

6. LIN-Receiver nach einem der Ansprüche 2 bis 5, bei dem zumindest ein vierter, ein fünfter und ein siebter Transistor (M4, M5, M7) derart zwischen die positive Versorgungsspannung (BVDD) und die negative Versorgungsspannung (BVSS) oder Masse geschaltet sind, dass ein Stromflussanteil durch den zweiten Widerstand (R2) des Spannungs-Zustrom-Wandlers (SSW) den Gateanschluss des siebten Transistors (M7) und darüber über den vierten und den fünften Transistor (M4, M5) ansteuert, den Stromanteil durch den zweiten Widerstand (R2) zu kompensieren.

7. LIN-Receiver nach einem der Ansprüche 3 bis 6, bei dem zu mindest ein achter und ein vierzehnter Transistor (M8, M14) derart zwischen die positive Versorgungsspannung (BVDD) und die negative Versorgungsspannung (BVSS) oder Masse geschaltet sind, dass sie einen Stromfluss durch den zweiten Widerstand (R2) bei rezessivem Pegel am Eingang (LINI) mittels eines Schalters ausschalten.

8. LIN-Receiver nach einem der Ansprüche 3 bis 7, bei dem ein Schalter (S) und zum Erzeugen einer Hysterese ein siebzehnter Transistor (M17) als zusätzliche Komponenten in Reihe zwischen den zweiten Widerstand (R2) und die negative Versorgungsspannung (BVSS) oder Masse geschaltet sind, wobei der Schalter (S) geschaltet ist, abhängig von einem Schaltungszustand am Ausgang (RXDO) einen Stromfluss durch den siebzehnten Transistor (M17) ein- oder auszuschalten.

9. LIN-Receiver nach einem der Ansprüche 2 bis 8, bei dem die Transistoren mittels Skalierungsfaktoren (m, n, 1) dimensioniert sind, al-Ströme außer jenen durch den ersten Widerstand (R₁) des Spannungs-zu-Strom-Wandlers (SSW) entsprechend zu reduzieren.

10. LIN-Receiver nach einem der Ansprüche 2 bis 9, bei dem ein sechzehnter Transistor (M16) als eine integrierte Verpolschutz-Diode zwischen die positive Versorgungsspannung (BVDD) und die weiteren Transistoren geschaltet ist.

## Claims

1. LIN receiver with sleep/wake-up functionality, comprising a circuit with:
- an input (LINI) as connecting point for an LIN bus (LIN), with a recessive state and a dominant state, and
- an output (RXDO), and
- terminals for at least one positive supply voltage (BVDD),
- with a plurality of transistors, and
- a first resistance (R1) and a second resistance (R2), wherein the second resistance is connected with a negative supply voltage (BVSS),
**characterised in that**
the input (LINI) is connected between the first resistance (R1), which is constructed as a pull-up, and the second resistance (R2) and in the dominant state a current flows by way of the first resistance (R1), which is constructed as a component of a current/voltage converter (SSW), and the circuit is activated, wherein a current flow component flows through the second resistance and the current flow component is compensated for by the second resistance **in that** the current flow component is mirrored at the input (LINI) and the overall circuit is current-free in the case of the recessive level apart from leakage currents.

2. LIN receiver according to claim 1, with
- at least first; second and third transistors (M1 - M3), which are connected in order to mirror the current flow by way of the first resistance (R1), and
- at least one eighth transistor and fourteenth transistor (M8, M14) and further twelfth, thirteenth and fifteenth transistors (M12, M13, M15), which are connected as cascade transistors and which are connected for switching the LIN receiver and/or the output (RXDO) to be active.

3. LIN receiver according to claim 1 or claim 2, in which
- the second resistance (R2) is a part of the voltage-to-current converter (SSW) and is switchably connected by means of transistors (M12, M6) to the negative supply voltage (BVSS) or ground.

4. LIN receiver according to claim 3, in which at least one third transistor and fifteenth transistor (M3, M15) are connected between the positive supply voltage (BVDD) and the negative supply voltage (BVSS) or ground for comparison of a current flow component through the first resistance (R1) and a current flow component through the second resistance (R2).

5. LIN receiver according to claim 4, in which a tenth transistor and an eleventh transistor (M10, M11) are connected at the output side with the third and fifteenth transistors (M3, M15) to draw the output (RXDO) to ground or the negative supply voltage of the bus (BVSS).

6. LIN receiver according to any one of claims 2 to 5, in which at least one fourth, fifth and seventh transistors (M4, M5, M7) are so connected between the positive supply voltage (BVDD) and the negative supply voltage (BVSS) or ground that a current flow component through the second resistance (R2) of the voltage-to-current converter (SSW) controls the gate connection of the seventh transistor (M7) and beyond that to compensate for the flow component through the second resistance (R2) by way of the fourth and fifth transistors (M4, M5).

7. LIN receiver according to any to any one of claims 3 to 6, in which at least one eighth transistor and fourteenth transistor (M8, M14) are so connected between the positive supply voltage (BVDD) and the negative supply voltage (BVSS) or ground that they switch off a current flow through the second resistance (R2) by means of a switch in the case of a recessive level at the input (LINI).

8. LIN receiver according to any one of claims 3 to 7, in which a switch (S) and, for producing a hysteresis, a seventeenth transistor (M17) are connected as additional components in series between the second resistance (R2) and the negative supply voltage (BVSS) or ground, wherein the switch (S) is connected to switch on or switch off a current flow through the seventeenth transistor (M17) in dependence on a switching state at the output (RXDO).

9. LIN receiver according to any one of claims 2 to 8, in which the transistors are dimensioned by means of scaling factors (m, n, 1) in order to appropriately reduce all currents apart from those through the first resistance (R1) of the voltage-to-current converter (SSW).

10. LIN receiver according to any one of claims 2 to 9, in which a sixteenth transistor (M16) is connected as an integrated pole protection diode between the positive supply voltage (BVDD) and the further transistors.

## Revendications

1. Récepteur LIN avec une fonction d'éveil/endormissement formé d'un circuit comprenant :
. une entrée (LINI) servant de point de connexion à un bus LIN (LIN) présentant un état récessif et un état dominant et
. une sortie (RXDO) et des raccordements avec au moins une tension positive d'alimentation (BVDD),
. plusieurs transistors et une première résistance (R1) et une deuxième résistance (R2) dans lequel la deuxième résistance est reliée à une tension négative d'alimentation (BVSS),
**caractérisé en ce que** :
l'entrée (LINI) est placée dans le circuit entre la première résistance (R1) en tant que résistance d'excursion haute et la deuxième résistance (R2) et dans l'état dominant à travers la première résistance (R1) qui est utilisée en tant que composant d'un convertisseur courant/tension (SSW) passe un courant et le circuit est activé, dans lequel une composante du flux de courant passe dans la deuxième résistance et la composante du flux de courant est compensée par la deuxième résistance, dans lequel la composante du flux de courant est inversée sur l'entrée (LINI) et la totalité du circuit dans le cas d'un niveau récessif se trouve sans courant jusqu'aux courants de fuite.

2. Récepteur LIN selon la revendication 1 comprenant
. au moins un premier, deuxième ou troisième transistors (M1-M3) montés dans le circuit pour inverser le flux de courant traversant la première résistance, et
. au moins un huitième et un quatorzième transistor (M8-M14) et d'autres douzième, treizième et quinzième transistors montés en cascade dans le circuit pour commuter dans l'état actif les récepteurs LIN et/ou la sortie (RXDO).

3. Récepteur LIN selon la revendication 1 ou la revendication 2 dans lequel la deuxième résistance (R2) est un composant du convertisseur tension/courant (SSW) et est montée dans le circuit pour se connecter au moyen des transistors (M12, M6) soit vers la tension d'alimentation négative (BVSS) soit vers la masse.

4. Récepteur LIN selon la revendication 3 dans lequel au moins un troisième ou un quinzième transistor (M3, M15) sont montés dans le circuit entre la tension positive d'alimentation (BVDD) et la tension négative d'alimentation (BVSS) ou la masse pour compenser une partie du flux de courant par la première résistance et une partie du flux de courant par la deuxième résistance (R2).

5. Récepteur LIN selon la revendication 4 dans lequel un dixième et un onzième transistor (M10, M11) sont montés dans le circuit du côté de la sortie avec le troisième et le quinzième transistor (M3, M15) pour tirer la sortie (RXDO) vers la masse ou la tension d'alimentation négative du bus (BVSS).

6. Récepteur LIN selon l'une des revendications 2 à 5 dans lequel au moins un quatrième, un cinquième et un septième transistor (M4, M5, M7) sont montés dans le circuit entre la tension d'alimentation positive (BVDD) et la tension d'alimentation négative (BVSS) ou la masse, en ce qu'une composante du flux de courant est amorcée par la deuxième résistance (R2) du convertisseur tension/courant (SSW) de l'électrode de gâchette du septième transistor (M7) et par delà le quatrième et le cinquième transistor (M4, M5) pour compenser la composante de courant par la deuxième résistance (R2).

7. Récepteur LIN selon l'une des revendications 3 à 6 dans lequel au moins un huitième et un quatorzième transistors (M8, M14) sont montés dans le circuit entre la tension d'alimentation positive (BVDD) et la tension d'alimentation négative (BVSS) ou la masse, de façon qu'ils déconnectent un flux de courant à travers la deuxième résistance (R2) par le niveau de récession à l'entrée (LINI) à l'aide d'un commutateur.

8. Récepteur LIN selon l'une des revendications 3 à 7 dans lequel sont montés dans le circuit, un commutateur (S) et un dix-septième transistor (M17) pour la génération d'une hystérésis en tant que composants supplémentaires en série entre la deuxième résistance (R2) et la tension d'alimentation négative (BVSS) ou la masse, dans lequel le commutateur (S) est mis oeuvre dans le circuit selon un état de circuit ouvert ou fermé à la sortie (RXDO) pour connecter ou déconnecter un flux de courant par le dix-septième transistor.

9. Récepteur LIN selon l'une des revendications 2 à 8 dans lequel les transistors étant dimensionnés au moyen de facteurs d'échelle (m, n, 1), tous les courants sont réduits proportionnellement à l'exception de ceux correspondant à la première résistance (R1) du convertisseur tension/courant (SSW).

10. Récepteur LIN selon l'une des revendications 2 à 9 dans lequel un seizième transistor (M16) est monté dans le circuit entre la tension positive d'alimentation (BVDD) et les autres transistors en tant que diode intégrée de protection d'inversion de polarité.
